# EUROPEAN PATENT APPLICATION

(11) **EP 2 958 408 A1**
(43) Date of publication of application: **23.12.2015**
(21) Application number: 13874923.9
(22) Date of filing: 12.02.2013
(51) Int. Cl.: H05K 3/46

(54) **SUBSTRATE WITH BUILT-IN COMPONENT, AND MANUFACTURING METHOD FOR SAME**

(71) Applicant: Meiko Electronics Co., Ltd., Ayase-shi, Kanagawa 252-1104 (JP)
(72) Inventor: SHIMADA, Hiroshi, Ayase-shi Kanagawa 252-1104 (JP); TODA, Mitsuaki, Ayase-shi Kanagawa 252-1104 (JP); MATSUMOTO, Tohru, Ayase-shi Kanagawa 252-1104 (JP)
(74) Representative: Epping - Hermann - Fischer
(86) International application number: PCT/JP2013/053255
(87) International publication number: WO 2014/125567

(57) **Abstract**

A device embedded substrate (15) includes an insulating layer (12) including an insulating resin material, an electric or electronic device (4) embedded in the insulating layer (12), a metal film (9) coating at least one face of the device (4), and a roughened portion (10) formed by roughening at least part of the surface of the metal film (9). Preferably, the device embedded substrate (15) further includes: a conductive layer (6) pattern-formed at least on a bottom face (7), the bottom face (7) being one face of the insulating layer (12); and a bonding agent (3) made of a material different from the insulating layer (12) and joining the conductive layer (6) and a mounting face (8), the mounting face (8) being one face of the device (4). The metal film (9) is formed only on a face opposite to the mounting face (8), and the bonding agent (3) has a thickness smaller than a thickness from the metal film (9) to a top face (11), the top face (11) being the other face of the insulating layer (12).

## Description

### Technical Field

The present invention relates to a device embedded substrate and a manufacturing method of device embedded substrate.

### Background Art

A device embedded substrate is disclosed in Patent Document 1. As described in Patent Document 1, the device embedded substrate is formed by mounting electric or electronic devices on a conductive layer to be used as a conductor pattern and embedding the devices by laminating them to an insulating layer such as a prepreg. There are various embedded devices including passive components, such as resistors and capacitors, and active components, such as transistors and diodes. Some of these various devices have a terminal and a metal film, the terminal being provided on the conductive layer side at the time of being mounted and the metal film being formed on a face opposite to the terminal. The metal film is formed of, for example, copper, silver, nickel, gold, titanium, or the like.

### Prior Art Document

### Patent Document

Patent Literature 1: Japanese Patent No. 4874305

### Summary of the Invention

### Problems to be solved by the Invention

However, when a device having a metal film is embedded, separation between the metal film and the insulating layer occurs. This separation is caused by low adhesion strength between the metal film and the insulating layer since the metal film has a surface roughness of about 0.01 µm. Conventionally, in order to avoid such phenomenon, a laser via extending to the metal film is formed after the device is laminated, and an inside of the via is plated. However, the device is fixed through this plating, which causes cracks to be generated on the device. These cracks are generated when the plating metal inside the via is moved outside by expansion of the prepreg, for example.

In consideration of the conventional technology, an object of the present invention is to provide a device embedded substrate and a manufacturing method therefor capable of preventing cracks on a device and enhancing adhesive strength between a metal film and an insulating layer when the device having the metal film is embedded in substrate.

### Means for Solving the Problems

In order to accomplish the object, there is provided in the present invention a device embedded substrate, including: an insulating layer including an insulating resin material; an electric or electronic device embedded in the insulating layer; a metal film coating at least one face of the device; and a roughened portion formed by roughening at least part of a surface of the metal film.

Preferably, the device embedded substrate further includes: a conductive layer pattern-formed at least on a bottom face, the bottom face being one face of the insulating layer; and a bonding agent made of a material different from the insulating layer and joining the conductive layer and a mounting face, the mounting face being one face of the device, wherein the metal film is formed only on a face opposite to the mounting face, and the bonding agent has a thickness smaller than a thickness from the metal film to a top face, the top face being the other face of the insulating layer.

Preferably, the roughened portion is formed on the entire surface of the metal film.

Preferably, the device embedded substrate further includes another device embedded in the insulating layer together with the device, wherein the other device has a face formed of a nonmetallic material, the face being on a side of the top face.

There is provided in the present invention a method for manufacturing the device embedded substrate, including: a mounting step of pasting a conductive foil on a support plate having rigidity and mounting an electric or electronic device on the conductive foil; a laminating step of embedding the device in the insulating layer; and a roughening step of roughening the metal film, the roughening step being performed before the laminating step.

There is further provided in the present invention a method for manufacturing the device embedded substrate, including: a mounting step of putting a conductive foil on a support plate having rigidity and mounting an electric or electronic device on the conductive foil; a first laminating step of laminating a first insulating base material to the device to embed the device in the first insulating base material; an exposing step of removing part of the first insulating base material to expose at least part of the metal film; a roughening step of roughening the exposed metal film; and a second laminating step of laminating a second insulating base material to the metal film and forming the insulating layer together with the first insulating base material to embed the device.

### Advantageous Effects of the Invention

According to the present invention, at least part of the metal film is provided with a roughened portion, so that adhesive strength between the device and the insulating layer is enhanced through the roughened portion, which can prevent separation between the device and the insulating layer. Furthermore, since resin and metal are fixed, cracks are not generated on the device.

When the mounting face of the device is mounted on the conductive layer with a bonding agent, such as adhesive agents and soldering pastes, and this bonding agent has a thickness smaller than the thickness from the metal film to the top face, a possibility of generation of cracks is low on the bonding agent side, and therefore, it is unnecessary to provide the roughened portion. Accordingly, a reliable device embedded substrate can be obtained simply by performing minimum roughening.

When the roughened portion is formed on the entire surface of the metal film, the adhesive strength between the device and the insulating layer can dramatically be enhanced.

Moreover, when the device is temporarily embedded in the first insulating base material, and then part of this first insulating base material is removed to expose part of the metal film, the roughened portion can selectively be formed on the metal film, which makes it possible to enhance the adhesive strength between the device and the insulating layer regardless of the shape of the device. Particularly when the device is adjacently embedded with another device which has a nonmetallic material on the top face side, the other device is embedded in the first insulating base material, and therefore only a portion desired to be roughened can be exposed and be roughened. This makes it possible to prevent damaging the other device and the soldering paste by roughening, and also enhances workability.

### Brief Description of the Drawings

FIG. 1 is a schematic view for describing a method for manufacturing a device embedded substrate according to the present invention in sequence.
FIG. 2 is a schematic view for describing the method for manufacturing the device embedded substrate according to the present invention in sequence.
FIG. 3 is a schematic view for describing the method for manufacturing the device embedded substrate according to the present invention in sequence.
FIG. 4 is a schematic view for describing the method for manufacturing the device embedded substrate according to the present invention in sequence.
FIG. 5 is a schematic view illustrating the device embedded substrate according to the present invention.
FIG. 6 is a schematic view for describing a method for manufacturing another device embedded substrate according to the present invention in sequence.
FIG. 7 is a schematic view for describing the method for manufacturing the other device embedded substrate according to the present invention in sequence.
FIG. 8 is a schematic view for describing the method for manufacturing the other device embedded substrate according to the present invention in sequence.
FIG. 9 is a schematic view illustrating the other device embedded substrate according to the present invention.
FIG. 10 is a schematic view for describing a method for manufacturing yet another device embedded substrate according to the present invention in sequence.
FIG. 11 is a schematic view for describing the method for manufacturing the yet another device embedded substrate according to the present invention in sequence.
FIG. 12 is a schematic view for describing the method for manufacturing the yet another device embedded substrate according to the present invention in sequence.
FIG. 13 is a schematic view illustrating the yet another device embedded substrate according to the present invention.

### Mode for Carrying out the Invention

First, a method for manufacturing a device embedded substrate according to the present invention is described.

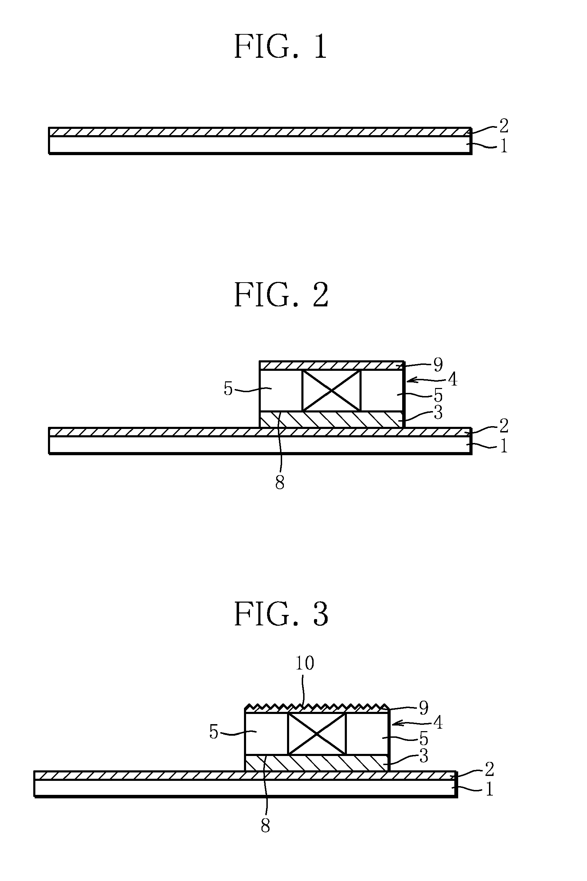

A mounting step is performed as illustrated in FIGS. 1 and 2. First, as illustrated in FIG. 1, a conductive foil 2 is put on a support plate 1 having rigidity. The conductive foil 2 is later used as a conductive layer. The support plate 1 to be used has rigidity to the degree required in processing conditions. For example, the support plate 1 is formed from a rigid stainless steel (SUS) board, an aluminum plate, or the like. When the support plate 1 is an SUS board, the conductive foil 2 can be formed by depositing copper plating thereon. When the support plate 1 is an aluminum plate, it can be formed by putting a copper foil thereto. Then, as illustrated in FIG. 2, an adhesive agent 3 made of an insulating material is applied by, for example, a dispenser, printing, or the like, on the conductive foil 2. An electric or electronic device 4 is mounted on this adhesive agent 3. The device 4 may be mounted on the conductive foil 2 with a soldering paste.

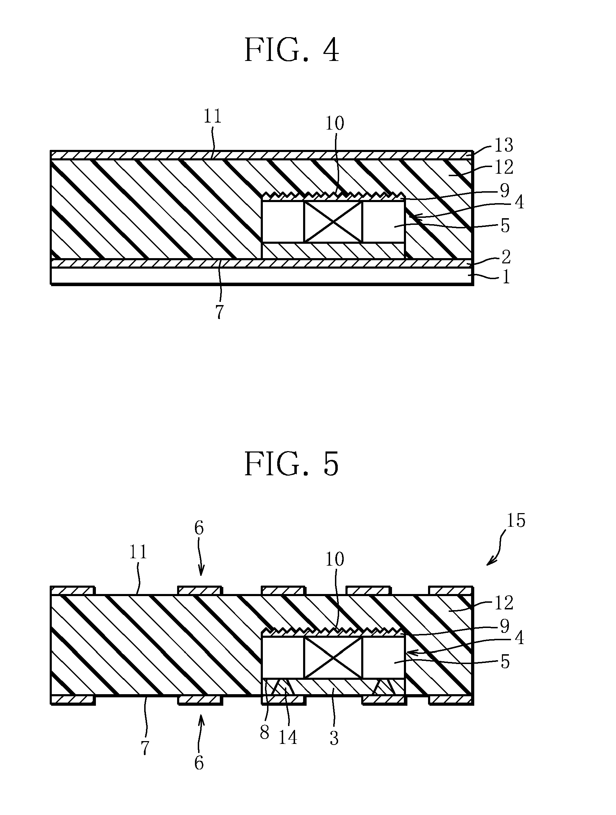

The device 4 has a terminal 5 which is later electrically connected with a conductive layer 6 (see FIG. 5), the conductive layer 6 being pattern-formed on a bottom face 7 (see FIG. 5) that is one face of the substrate. In this example, the terminal 5 is exposed to the mounting face 8 side that is one face of the device 4. A face of the device 4 opposite to the mounting face 8 is coated with a metal film 9. The metal film is formed of copper, for example.

Next, a roughening step is performed as illustrated in FIG. 3. A roughening step is for roughening the metal film 9. The roughening is achieved by etching roughening which involves chemical etching, for example. In this roughening, the metal film 9 having a surface roughness of 0.01 µm is roughened to have a surface roughness of about 0.3 to 5 µm. A roughened portion 10 is formed on the surface of the metal film 9 by the roughening. FIG. 3 illustrates an example in which the roughened portion 10 is formed on the entire surface of the metal film.

Next, a laminating step is performed as illustrated in FIG. 4. The laminating step is for embedding the device 4 in an insulating layer 12. Specifically, the insulating layer 12 is formed by laminating an insulating base material, which includes an insulating resin material different from the material of the adhesive agent 3, to the device 4 and by pressing and heating the insulating base material. The insulating base material may be formed by preparing a plurality of perforated materials with a portion of the device 4 being removed or a plurality of so-called core materials (unclad materials) and by laying these materials on top of each other to form the insulating layer 12. As an insulating base material, a prepreg is mainly used. As a core material, for example, a metal plate to be inserted into a multilayer printed wiring board as a core or a pattern-formed laminate is used. In the insulating layer 12 formed by lamination, the face on which the device 4 is mounted serves as a bottom face 7 as mentioned before, and a face opposite to the bottom face serves as a top face 11. During lamination, another conductive foil 13 is also laminated on the top face 11 side.

Next, as illustrated in FIG. 5, a conductive layer forming step is performed. In this step, the support plate 1 is removed first. Next, laser or the like is used to form a via going through the adhesive agent 3 and to the terminal 5. The via is then subjected to plating processing so that a filled via 14 is formed. Then, etching or the like is performed to form a conductive layer 6 serving as a circuit pattern. The via may be formed not only by the laser but also by high-frequency laser, such as UV-YAG or excimer laser.

The device embedded substrate 15 formed in this way has a roughened portion 10 provided on the surface of the metal film 9, so that adhesive strength between the device 4 and the insulating layer 12 is enhanced through the roughened portion 10, which can prevent separation between the device 4 and the insulating layer 12. Furthermore, the insulating layer 12 made of resin and the metal film 9 made of metal are fixed while they are directly in close contact with each other. Accordingly, cracks are not generated on the device 4. When the adhesive agent 3 has a thickness smaller than a thickness from the metal film 9 to the top face 11 of the insulating layer 12, the metal film 9 may be provided only on the face opposite to the mounting face 8 of the device 4. In this case, a possibility of generation of cracks is low on the adhesive agent 3 side, which makes it unnecessary to provide the roughened portion 10. Accordingly, a reliable device embedded substrate 15 can be obtained simply by performing minimum roughening. Since the roughened portion 10 is provided on the entire metal film 9 in the example of FIG. 5, the adhesive strength between the device 4 and the insulating layer 12 can dramatically be enhanced.

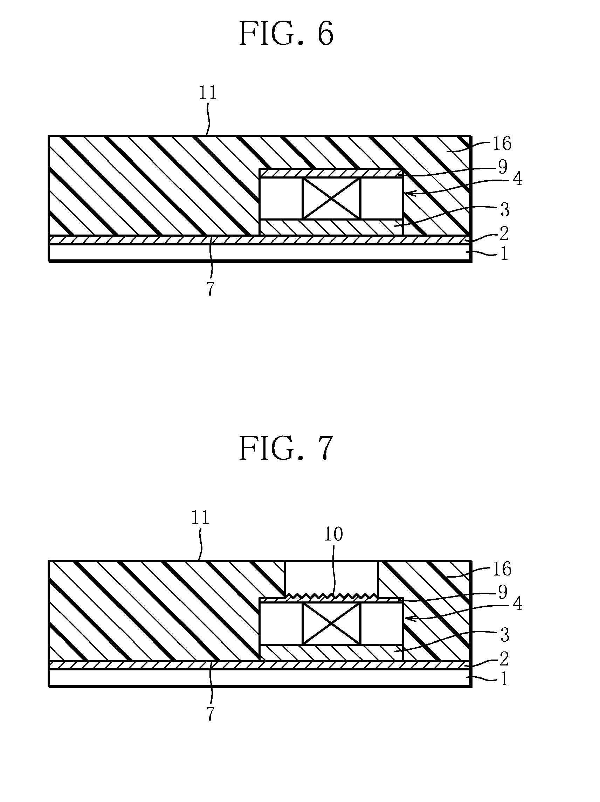

To provide the roughened portion 10 only in part of the metal film 9, the following manufacturing process is employed. The procedures up to the mounting step are similar to the example described before. After the mounting step, a first laminating step is performed without performing the roughening step (state of FIG. 6). In the first laminating step, a first insulating base material 16 is laminated to the device 4, so that the device 4 is embedded in the first insulating base material 16. Then, as illustrated in FIG. 7, an exposing step and a roughening step are performed. In the exposing step, part of the first insulating base materials 16 is removed by laser or the like, so that part of the metal film 9 is exposed. The exposed portion is subjected to roughening, as a result of which the roughened portion 10 is formed.

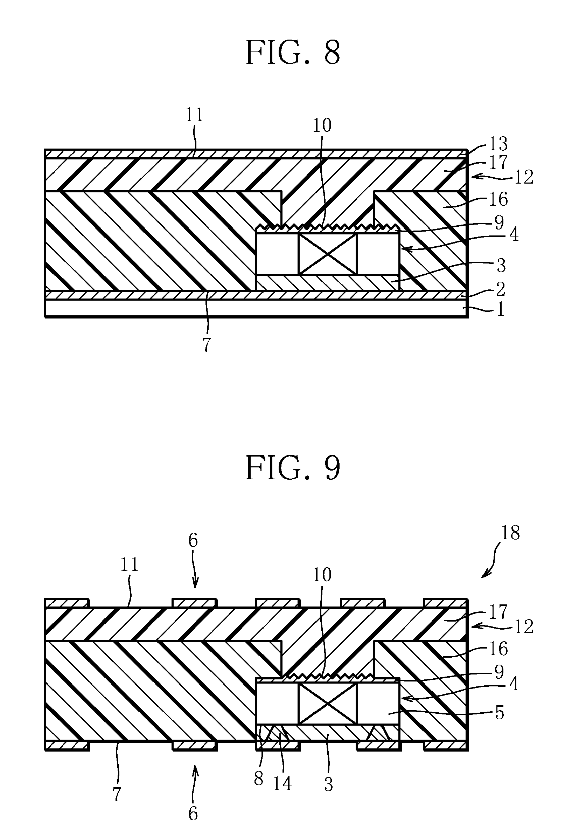

Then, as illustrated in FIG. 8, a second laminating step is performed. In the second laminating step, a second insulating base material 17 is further laminated to the metal film 9 having the roughened portion 10 provided thereon. The first and second insulating base materials 16 and 17 form an insulating layer 12, and the device 4 is embedded in the insulating layer 12. Then, the aforementioned conductive layer forming step is performed, so that a device embedded substrate 18 having part of the metal film 9 being roughened is manufactured. When there are restrictions on formation of the roughened portion 10 on the entire surface of the metal film 9 due to the shape of the device 4 or in terms of layout, the roughened portion 10 may also selectively be formed. The first and second insulating base materials 16 and 17 may be made of the same material, or be made of different materials. After the second insulating base material 17 is laminated, yet another insulating base material may be laminated to form a multilayered insulating layer 12. Although the roughened portion 10 is provided in part of the metal film 9 in the above example, the roughened portion 10 may be provided on the entire surface of the metal film 9.

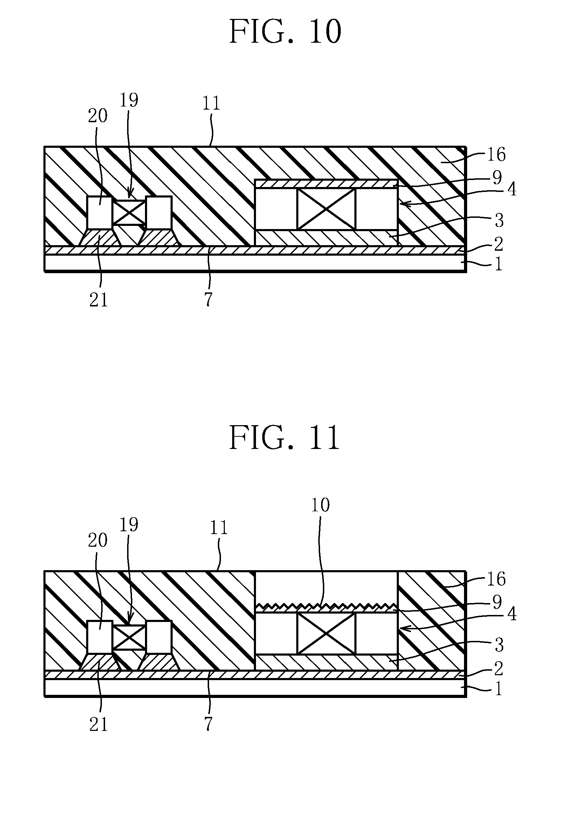

In the case of embedding another device 19 together with the device 4 in the insulating layer 12, the following manufacturing process is employed. The procedures up to the first laminating step are similar to the manufacturing process of the device embedded substrate 18 of FIG. 9 described before. In this case, the other device 19 adjacent to the device 4 is also mounted and embedded together with the device 4. In the example of FIG. 10, the other device 19 is configured so that its terminal 20 and the conductive foil 2 are joined with a soldering paste 21. The other device 19 has a face formed of a nonmetallic material, the face being on the side of the top face 11.

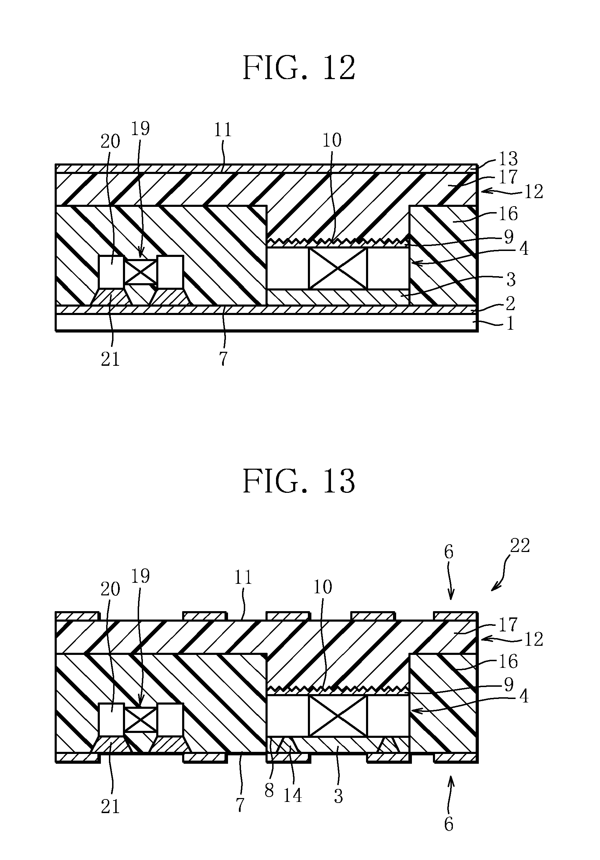

Then, the exposing step and the roughening step are performed (state of FIG. 11). First, perforation processing is performed by laser or the like to expose the metal film 9. Although the entire surface of the metal film 9 is exposed in the example of FIG. 11, part of the metal film 9 may be exposed as illustrated in FIG. 7. Then roughening is performed as in the example described before to form the roughened portion 10. Then, like the example of FIG. 8 described before, the second laminating step is performed (state of FIG. 12), and the conductive layer forming step is performed to manufacture a device embedded substrate 22 as illustrated in FIG. 13. Although the device embedded substrate 22 manufactured in this way also incorporates the other device 19 having the surface made of a nonmetallic material, only the desired metal film 9 can be roughened while the other device 19 is not influenced by the roughening. More specifically, since the other device 19 is covered with the first insulating base material 16, etching solution does not affect the other device 19 at the time of roughening. Accordingly, only the portion to be roughened may be exposed for roughening, so that workability is enhanced.

### Explanation of Reference Signs

- 1: Support plate
- 2: Conductive foil
- 3: Adhesive agent (bonding agent)
- 4: Electric or electronic device
- 5: Terminal
- 6: Conductive layer
- 7: Bottom face
- 8: Mounting face
- 9: Metal film
- 10: Roughened portion
- 11: Top face
- 12: Insulating layer
- 13: Conductive foil
- 14: Filled via
- 15: Device embedded substrate
- 16: First insulating base material
- 17: Second insulating base material
- 18: Device embedded substrate
- 19: Another device
- 20: Terminal
- 21: Soldering paste
- 22: Device embedded substrate

## Claims

1. A device embedded substrate, comprising:
an insulating layer including an insulating resin material;
an electric or electronic device embedded in the insulating layer;
a metal film coating at least one face of the device; and
a roughened portion formed by roughening at least part of a surface of the metal film.

2. The device embedded substrate according to claim 1, further comprising:
a conductive layer pattern-formed at least on a bottom face, the bottom face being one face of the insulating layer; and
a bonding agent made of a material different from the insulating layer and joining the conductive layer and a mounting face, the mounting face being one face of the device, wherein
the metal film is formed only on a face opposite to the mounting face, and
the bonding agent has a thickness smaller than a thickness from the metal film to a top face, the top face being the other face of the insulating layer.

3. The device embedded substrate according to claim 2, wherein the roughened portion is formed on the entire surface of the metal film.

4. The device embedded substrate according to claim 2, further comprising:
another device embedded in the insulating layer together with the device, wherein
the other device has a face formed of a nonmetallic material, the face being on a side of the top face.

5. A method for manufacturing the device embedded substrate according to claim 1, comprising:
a mounting step of putting a conductive foil on a support plate having rigidity and mounting an electric or electronic device on the conductive foil;
a laminating step of embedding the device in the insulating layer; and
a roughening step of roughening the metal film, the roughening step being performed before the laminating step.

6. A method for manufacturing the device embedded substrate according to claim 1, comprising:
a mounting step of putting a conductive foil on a support plate having rigidity and mounting an electric or electronic device on the conductive foil;
a first laminating step of laminating a first insulating base material to the device to embed the device in the first insulating base material;
an exposing step of removing part of the first insulating base material to expose at least part of the metal film;
a roughening step of roughening the exposed metal film; and
a second laminating step of laminating a second insulating base material to the metal film and forming the insulating layer together with the first insulating base material to embed the device.
